# EUROPEAN PATENT APPLICATION

(11) **EP 4 711 835 A1**
(43) Date of publication of application: **18.03.2026**
(21) Application number: 24807385.0
(22) Date of filing: 19.04.2024
(51) Int. Cl.: G02B 27/01, G06F 1/20, G06F 1/16, H05K 7/20

(54) **HEAT DISSIPATION MEMBER AND WEARABLE ELECTRONIC DEVICE COMPRISING HEAT DISSIPATION MEMBER**

(30) Priority: 12.05.2023 KR 20230061900; 16.06.2023 KR 20230077324
(71) Applicant: Samsung Electronics Co., Ltd., Suwon-si, Gyeonggi-do 16677 (KR)
(72) Inventor: KIM, Musul, Suwon-si Gyeonggi-do 16677 (KR); JUNG, Sangchul, Suwon-si Gyeonggi-do 16677 (KR); KIM, Kwangtai, Suwon-si Gyeonggi-do 16677 (KR); KIM, Seungnyun, Suwon-si Gyeonggi-do 16677 (KR)
(74) Representative: Nederlandsch Octrooibureau
(86) International application number: PCT/KR2024/005352
(87) International publication number: WO 2024/237506

(57) **Abstract**

The present disclosure relates to a wearable electronic device. A wearable electronic device, according to one embodiment of the present disclosure, comprises: a display formed to generate visual information; a lens formed to transmit the visual information displayed on the display; a plurality of lamps spaced apart from each other along a circumferential direction of the lens; a substrate electrically connected to the plurality of lamps and extending along a circumferential direction of the lens; and a heat dissipation member at least partially extending in a direction in which the substrate extends so as to be capable of heat exchange with the substrate. Various other embodiments are possible.

## Description

### [Technical Field]

Various embodiments of the disclosure relate to a wearable electronic device, e.g., a heat dissipation member and a wearable electronic device including the same.

### [Background Art]

Portable electronic devices, such as electronic schedulers, portable multimedia players, mobile communication terminals, or tablet PCs, are generally equipped with a display member (e.g., a display) and a battery, and come in bar, clamshell, or slidable shape by the shape of the display member or battery. As display members and batteries are nowadays made smaller and have enhanced performance, wearable electronic device which may be put on the user's wrist, head, or other body portions are commercially available. Wearable electronic devices may be directly worn on the human body, presenting better portability and user accessibility.

Among wearable electronic devices, some electronic devices, e.g., head-mounted devices (HMDs), may be worn on the user's face. The head-mounted device may be usefully used to implement virtual reality or augmented reality. For example, the wearable electronic device may stereoscopically provide the image of the virtual space in the game played on TV or computer monitor and may implement virtual reality by blocking the real-world image. Other types of wearable electronic devices may implement virtual images while providing an environment in which the real-world image of the space where the user actually stays may be visually perceived, thereby providing augmented reality to provide various pieces of visual information to the user.

The information may be provided as related art for the purpose of helping understanding of the disclosure. No claim or determination is made as to whether any of the foregoing is applicable as background art in relation to the disclosure.

### [Detailed Description of the Invention]

### [Technical Solution]

An electronic device according to an embodiment of the disclosure includes a display generating visual information, a lens configured to allow the visual information displayed on the display to be transmitted through the lens, a plurality of lamps spaced apart from each other along a circumferential direction of the lens, a substrate electrically connected to the plurality of lamps and extending in a direction in which the plurality of lamps are spaced apart, and a heat dissipation member having at least a portion extending in a direction in which the substrate extends so as to enable heat exchange with the substrate.

An electronic device according to an embodiment of the disclosure includes a display generating visual information, a lens configured to allow the visual information displayed on the display to be transmitted through the lens, a plurality of lamps spaced apart from each other along a circumferential direction of the lens, a window through which the visual information transmitted through the lens and light emitted from the plurality of lamps are transmitted, a substrate electrically connected to the plurality of lamps and extending in a direction in which the plurality of lamps are spaced apart, and a thermal insulation member disposed between the plurality of lamps and the window.

### [Brief Description of Drawings]

FIG. 1 is a block diagram illustrating an electronic device in a network environment according to an embodiment.
FIG. 2 is a perspective view illustrating an internal configuration of a wearable electronic device according to an embodiment of the disclosure.
FIG. 3 is a view illustrating a front surface of a wearable electronic device according to an embodiment of the disclosure.
FIG. 4 is a view illustrating a rear surface of a wearable electronic device according to an embodiment of the disclosure.
FIG. 5 illustrates a portion of a wearable electronic device worn by a user according to an embodiment of the disclosure.
FIG. 6 is an exploded view illustrating a portion of a wearable electronic device according to an embodiment of the disclosure.
FIG. 7A is a top view illustrating a portion of a wearable electronic device according to an embodiment of the disclosure.
FIG. 7B illustrates a state in which a portion of the structure of FIG. 7A is removed.
FIG. 8 illustrates the structure of FIG. 7B cut along line A-A'.
FIG. 9A is an enlarged view illustrating area S of FIG. 8 according to an embodiment of the disclosure.
FIG. 9B is an enlarged view illustrating area S of FIG. 8 according to an embodiment of the disclosure.
FIG. 10 illustrates a portion of a wearable electronic device according to an embodiment of the disclosure.
FIG. 11 is a cross-sectional view illustrating a portion of a wearable electronic device according to an embodiment of the disclosure.
FIG. 12A illustrates a wearable electronic device according to an embodiment of the disclosure.
FIG. 12B illustrates the structure illustrated in FIG. 12A cut along line B-B'.
FIG. 12C is an enlarged view illustrating area S4 illustrated in FIG. 12B.
FIG. 13 is a contour describing effects of a wearable electronic device according to an embodiment of the disclosure.

### [Mode for Carrying out the Invention]

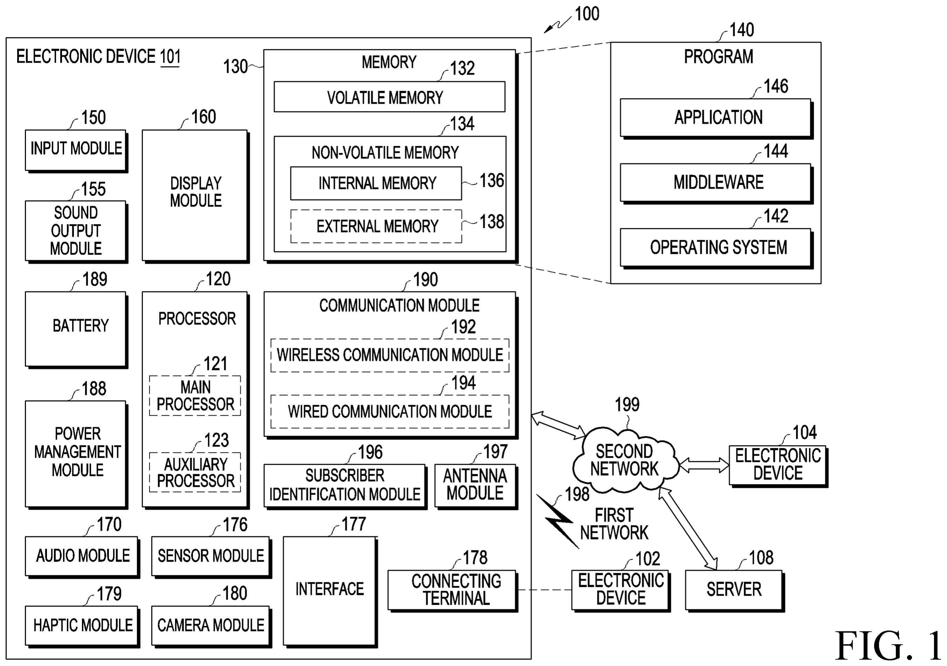

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., the program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operation state (e.g., power or temperature) of the electronic device 101 or an external environmental state (e.g., the user's state), and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

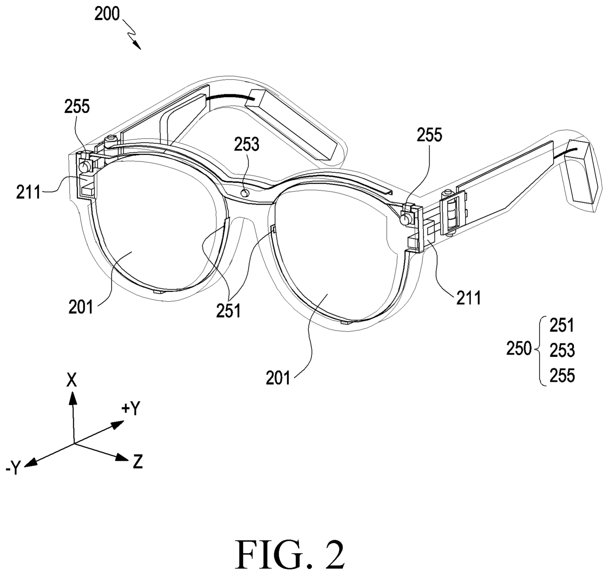

FIG. 2 is a perspective view illustrating an internal configuration of a wearable electronic device according to an embodiment of the disclosure;

Referring to FIG. 2, according to an embodiment of the disclosure, a wearable electronic device 200 may include at least one of a light output module 211, a display member 201, and a camera module 250.

According to an embodiment, the wearable electronic device 200 may be a body-worn device. For example, the wearable electronic device 200 may be a head-mounted device (HMD), smart glasses, or video see through (VST) capable of providing images directly in front of the user's eyes. In the illustrated embodiment, the wearable electronic device 200 is illustrated as having the appearance of goggles, but the wearable electronic device 200 of the disclosure is not limited thereto and may have various types of appearances. The wearable electronic device 200 may provide a pass through function. The wearable electronic device 200 may be referred to as a pass through device.

According to an embodiment of the disclosure, the light output module 211 may include a light source capable of outputting an image and a lens guiding the image to the display member 201. According to an embodiment of the disclosure, the light output module 211 may include at least one of a liquid crystal display (LCD), a digital mirror device (DMD), a liquid crystal on silicon (LCoS), a light emitting diode (LED on silicon (LEDoS), an organic light emitting diode (OLED), or a micro light emitting diode (micro LED). The light output module 211 may be referred to as a "display."

According to an embodiment of the disclosure, the display member 201 may include an optical waveguide (e.g., a waveguide). According to an embodiment of the disclosure, the image output from the light output module 211 incident on one end of the optical waveguide may propagate inside the optical waveguide and be provided to the user. According to an embodiment of the disclosure, the light waveguide may include at least one of a diffractive optical element (DOE), a holographic optical element (HOE), or a reflective element (e.g., a reflective mirror). For example, the light waveguide may guide an output image of the light output module 211 to the user's eye by including at least one of a diffractive optical element, a holographic optical element, or a reflective element (e.g., a reflective mirror).

According to an embodiment of the disclosure, the camera module 250 may capture still images and/or moving images. According to an embodiment, the camera module 250 may be disposed in a lens frame and may be disposed around the display member 201.

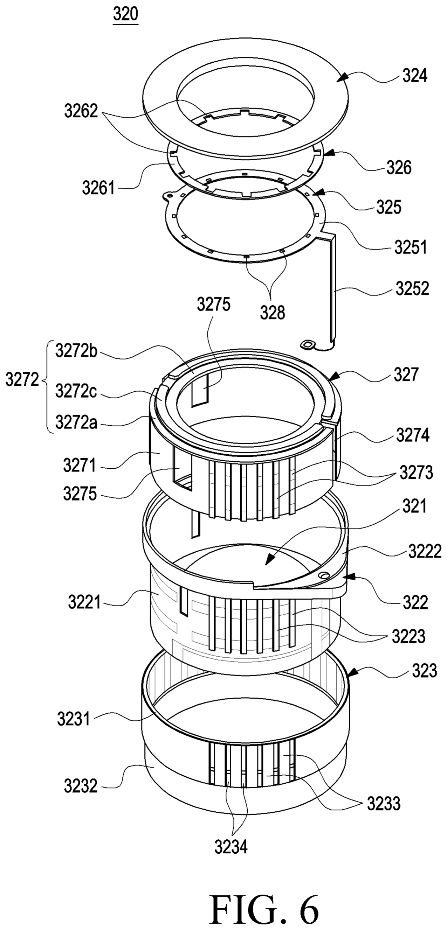

According to an embodiment of the disclosure, a first camera module 251 may capture and/or recognize the trajectory of the user's eye (e.g., pupil or iris) or gaze. According to an embodiment of the disclosure, the first camera module 251 may periodically or aperiodically transmit information related to the trajectory of the user's eye or gaze (e.g., trajectory information) to a processor (e.g., the processor 120 of FIG. 1). The first camera module 251 may receive light emitted from a lamp (e.g., the lamp 328 of FIG. 6) and reflected from the user's eye.

According to an embodiment of the disclosure, a second camera module 253 may capture an external image.

According to an embodiment of the disclosure, a third camera module 255 may be used for hand detection and tracking, and recognition of the user's gesture (e.g., hand motion). According to an embodiment of the disclosure, the third camera module 255 may be used for 3 degrees of freedom (3DoF) or 6DoF head tracking, location (space, environment) recognition and/or movement recognition. The second camera module 253 may also be used for hand detection and tracking and recognition of the user's gesture. According to an embodiment of the disclosure, at least one of the first camera module 251 to the third camera module 255 may be replaced with a sensor module (e.g., a LiDAR sensor). For example, the sensor module may include at least one of a vertical cavity surface emitting laser (VCSEL), an infrared sensor, and/or a photodiode.

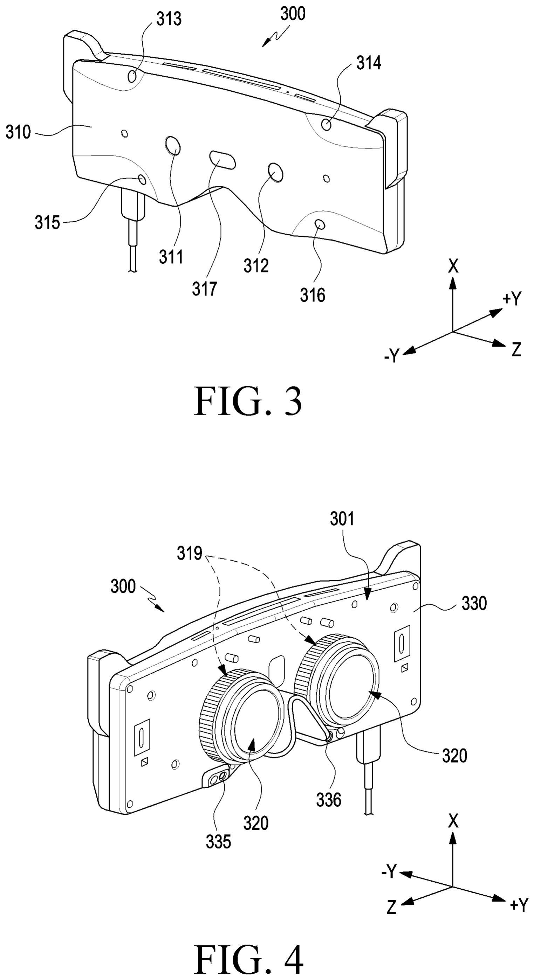

FIGS. 3 and 4 are views illustrating a front surface and a rear surface of a wearable electronic device 300 according to an embodiment.

Referring to FIGS. 3 and 4, in an embodiment, the wearable electronic device 300 may include a housing 301. The housing 301 may include a first surface 310 and a second surface 330.

Referring to FIGS. 3 and 4, in an embodiment, camera modules 311, 312, 313, 314, 315, and 316 and/or a depth sensor 317 for obtaining information related to the ambient environment of the wearable electronic device 300 may be disposed on the first surface 310 of the housing 301.

In an embodiment, the camera modules 311 and 312 may obtain images related to the ambient environment of the wearable electronic device 300.

In an embodiment, the camera modules 313, 314, 315, and 316 may obtain images while the wearable electronic device 300 is worn by the user. The camera modules 313, 314, 315, and 316 may be used for hand detection, tracking, and recognition of the user gesture (e.g., hand motion). The camera modules 313, 314, 315, and 316 may be used for 3DoF or 6DoF head tracking, location (space or environment) recognition, and/or movement recognition. In an embodiment, the camera modules 311 and 312 may be used for hand detection and tracking and recognition of the user's gesture.

In an embodiment, the depth sensor 317 may be configured to transmit a signal and receive a signal reflected from an object and be used for identifying the distance to the object, such as time of flight (TOF). Alternatively or additionally to the depth sensor 317, the camera modules 313, 314, 315, and 316 may identify the distance to the object.

According to an embodiment, the wearable electronic device 300 may include a display 319. The display 319 may output visual information through the lens assembly 320. The display 319 may be the same as the light output module 211 described with reference to FIG. 2.

According to an embodiment, face recognition camera modules 335, 336 and/or the lens assembly 320 (and/or the display) may be disposed on the second surface 330 of the housing.

In an embodiment, the face recognition camera modules 335 and 336 adjacent to the display may be used for recognizing the user's face or may recognize and/or track both eyes of the user.

In an embodiment, the lens assembly 320 (and/or the display) may be disposed on the second surface 330 of the wearable electronic device 300. In an embodiment, the wearable electronic device 300 may not include the camera modules 315 and 316 among the plurality of camera modules 313, 314, 315, and 316. Although not shown in FIGS. 3 and 4, the wearable electronic device 300 may further include at least one of the components shown in FIG. 2.

As described above, according to an embodiment, the wearable electronic device 300 may have a form factor to be worn on the user's head. The wearable electronic device 300 may further include a strap and/or a wearing member to be fixed on the user's body part. The wearable electronic device 300 may provide the user experience based on augmented reality, virtual reality, and/or mixed reality while worn on the user's head.

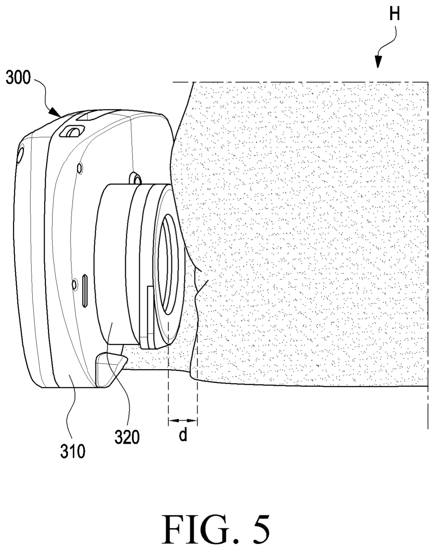

FIG. 5 illustrates a state in which a user H wears the wearable electronic device 300 with a portion removed according to an embodiment of the disclosure. FIG. 5 illustrates a portion of a wearable electronic device 300 worn by a user according to an embodiment of the disclosure. The components described with reference to FIG. 5 may be identical in whole or part to the components described with reference to FIGS. 1 to 4. Some or all of the components described with reference to FIG. 5 may be the same as those described with reference to FIGS. 6 to 13.

According to an embodiment, the user H may wear the wearable electronic device 300. The wearable electronic device 300 may be worn at a position adjacent to the eyes of the user H.

According to an embodiment, the wearable electronic device 300 may include a housing 301. The description of the housing 301 may be the same as the description of the housing (e.g., 301 of FIGS. 1 to 4) described with reference to FIGS. 1 to 4. The housing 301 may provide a space in which components of the wearable electronic device 300 (e.g., the display 211 of FIG. 2) are disposed.

According to an embodiment, the wearable electronic device 300 may include a lens assembly 320. The description of the lens assembly 320 may be the same as the description of the lens assembly (e.g., the lens assembly 320 of FIG. 4) described with reference to FIGS. 1 to 4. The lens assembly 320 may be coupled to the housing 301. The lens assembly 320 may protrude outward from the housing 301. When the user H wears the wearable electronic device 300, the lens assembly 320 may protrude from the housing 301 toward the eyes of the user H. The lens assembly 320 may be spaced apart from the eyes of the user H, and a gap D may be formed between the lens assembly 320 and the eyes of the user H.

According to an embodiment, the lens assembly 320 may have a cylindrical shape. A plurality of lens assemblies 320 may be disposed, and two may be disposed. The plurality of lens assemblies 320 may be spaced apart from each other.

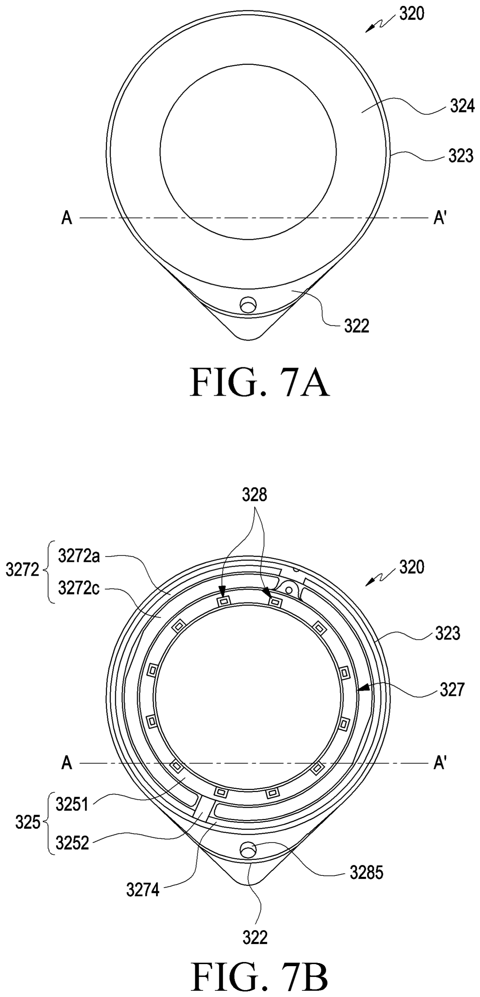

FIG. 6 is an exploded view illustrating the lens assembly 320 according to an embodiment of the disclosure. FIG. 6 is an exploded view illustrating a portion of the wearable electronic device 300 according to an embodiment of the disclosure. The components described with reference to FIG. 6 may be identical in whole or part to the components described with reference to FIGS. 1 to 5. The components described with reference to FIG. 6 may be identical in whole or part to the components described with reference to FIGS. 7A to 13.

According to an embodiment, the lens assembly 320 may include a lens 321. The plurality of lenses 321 may be disposed to be spaced apart from each other. A visual image output from the light output module (e.g., the light output module 211 of FIG. 2) may pass through the lens 321 and be delivered to the user. The lens 321 may be disposed inside the first lens barrel 322.

According to an embodiment, the lens assembly 320 may include a first lens barrel 322. The first lens barrel 322 may be disposed to surround the lens 321. The first lens barrel 322 may have a cylindrical shape. The first lens barrel 322 may include a first circumferential wall 3221. The first circumferential wall 3221 may have a cylindrical shape. The lens 321 may be disposed inside the first circumferential wall 3221. The first lens barrel 322 may include a lens barrel protrusion 3222. The lens barrel protrusion 3222 may protrude from the first circumferential wall 3221 radially outward from the first circumferential wall 3221. The first lens barrel 322 may include a first hole 3223. The first hole 3223 may be opened in at least a portion of the first circumferential wall 3221. The first hole 3223 may have a slit shape. A plurality of first holes 3223 may be formed spaced apart in the circumferential direction of the first circumferential wall 3221. The first lens barrel 322 may extend along the circumferential direction of the lens 321. The first lens barrel 322 may be referred to as a "lens barrel."

According to an embodiment, the first lens barrel 322 may include a heat transfer portion (e.g., a portion of the first circumferential wall 3221). The heat transfer portion may form an outer circumferential surface of the first lens barrel 322. The first lens barrel 322 according to an embodiment of the disclosure may have the heat transfer portion formed at a position where the first hole 3223 is formed. For example, the first lens barrel 322 may not include the first hole 3223 and may include the heat transfer portion formed at a position where the first hole 3223 illustrated in FIG. 6 is formed. The heat transfer portion may contact the heat dissipation fin 3273 and may face the second hole 3234.

According to an embodiment, the lens assembly 320 may include a second lens barrel 323. The second lens barrel 323 may be disposed to surround at least a portion of the first lens barrel 322. The second lens barrel 323 may have a cylindrical shape. The second lens barrel 323 may include a first frame 3231. The first frame 3231 may have a ring shape. The first frame 3231 may surround an upper portion of the first lens barrel 322. The second lens barrel 323 may include a second frame 3232. The second frame 3232 may have a ring shape. The second frame 3232 may surround a lower portion of the first lens barrel 322. The first frame 3231 and the second frame 3232 may be spaced apart from each other. The second lens barrel 323 may include a second circumferential wall 3233. The second circumferential wall 3233 may surround at least a portion of the first circumferential wall 3221. The second circumferential wall 3233 may be disposed between the first frame 3231 and the second frame 3232. A plurality of second circumferential walls 3233 may be disposed to be spaced apart from each other in the circumferential direction of the first lens barrel 322. The second lens barrel 323 may include a second hole 3234. The second hole 3234 may be formed between the plurality of second circumferential walls 3233. A plurality of second holes 3234 may be formed spaced apart from each other in the circumferential direction of the first lens barrel 322. The plurality of second holes 3234 may correspond to each of the plurality of first holes 3223. The first hole 3223 and the second hole 3234 may communicate with each other. The second lens barrel 323 may extend along the circumferential direction of the lens 321. The second lens barrel 323 may be referred to as a "lens barrel."

According to an embodiment, the lens assembly 320 may include lens barrels 322, 323. The lens barrels 322, 323 may include the first lens barrel 322. The lens barrels 322, 323 may include the second lens barrel 323. The lens barrel may include only one of the first lens barrel 322 and the second lens barrel 323. For example, the lens barrel may include only the first lens barrel 322.

According to an embodiment, the lens assembly 320 may include a window 324. The window 324 may have a ring shape. The window 324 may extend along the circumferential direction of the lens 321. The window 324 may extend along the circumferential direction of the lens barrels 322, 323.

According to an embodiment, the lens assembly 320 may include a substrate 325. The substrate 325 may be a flexible printed circuit board (FPCB). At least a portion of the substrate 325 may have a ring shape. The substrate 325 may extend along the circumferential direction of the lens 321. The substrate 325 may extend along the circumferential direction of the lens barrels 322, 323. The substrate 325 may include a first substrate portion 3251. The first substrate portion 3251 may extend along the circumferential direction of the lens 321. The first substrate portion 3251 may have a ring shape. The substrate 325 may include a second substrate portion 3252. The second substrate portion 3252 may extend to one side of the first substrate portion 3251. The second substrate portion 3252 may extend in a direction crossing the extending direction of the first substrate portion 3251.

According to an embodiment, the lens assembly 320 may include a substrate cover 326. The substrate cover 326 may be disposed between the window 324 and the substrate 325. The substrate cover 326 may extend in a direction in which the substrate 325 extends. The substrate cover 326 may have a ring shape. The substrate cover 326 may include a cover body 3261. The cover body 3261 may extend in the extending direction of the first substrate portion 3251. The substrate cover 326 may include a lamp insertion portion 3262. The lamp insertion portion 3262 may be formed in the cover body 3261. The plurality of lamp insertion portions 3262 may be formed spaced apart from each other in the extending direction of the cover body 3261. The lamp 328 may be inserted into the lamp insertion portion 3262.

According to an embodiment, the lens assembly 320 may include a lamp 328. The lamp 328 may be an "IR LED." The lamp 328 may emit infrared light. The lamp 328 may emit infrared light toward the user's eye. Light emitted from the lamp 328 may be reflected from the user's eye. The lens assembly 320 may include a camera (e.g., the camera 3285 of FIG. 7B) that receives infrared light reflected from the user's eye. The lens assembly 320 may include a camera (e.g., the camera 3285 of FIG. 7B) that obtains a pattern of light generated in the user's eye by the lamp 328. The lens assembly 320 may include a sensor (not illustrated) that recognizes the iris position of the user's eye based on information about infrared light received by the camera (e.g., the camera 3285 of FIG. 7B). The sensor (not illustrated) may perform an eye tracking function based on information about infrared light. The camera (e.g., the camera 3285 of FIG. 7B) may be the same as the first camera module 251 described with reference to FIG. 2.

According to an embodiment, the lamp 328 may be disposed on the substrate 325. The lamp 328 may be fixed to the first substrate portion 3251. A plurality of lamps 328 may be disposed. The plurality of lamps 328 may be spaced apart from each other in the circumferential direction of the substrate 325. The lamp 328 may receive power through the substrate 325. The lamp 328 may emit heat.

According to an embodiment, the lens assembly 320 may include a heat dissipation member 327. The heat dissipation member 327 may have a cylindrical shape. The heat dissipation member 327 may be disposed inside the lens barrels 322, 323. The first lens barrel 322 may surround the heat dissipation member 327. The heat dissipation member 327 may be coupled to the substrate 325. The substrate 325 may be seated on the heat dissipation member 327. Heat generated from the lamp 328 may be transferred to the heat dissipation member 327. At least a portion of the heat dissipation member 327 may include a metal material. At least a portion of the heat dissipation member 327 may include a material having higher thermal conductivity than the lens barrels 322, 323. The heat dissipation member 327 may be referred to as a "heat pipe." The heat dissipation member 327 may be referred to as a "heat sink."

According to an embodiment, the heat dissipation member 327 may include an outer circumferential wall 3271. The outer circumferential wall 3271 may have a cylindrical shape. The outer circumferential wall 3271 may extend in the circumferential direction of the lens 321. The lens 321 may be disposed inside the outer circumferential wall 3271. The first lens barrel 322 may surround the outer circumferential wall 3271.

According to an embodiment, the heat dissipation member 327 may include a support wall 3272. The support wall 3272 may have a ring shape. The support wall 3272 may extend in the extending direction of the substrate 325. The support wall 3272 may be coupled to the outer circumferential wall 3271. The support wall 3272 may be integral with the outer circumferential wall 3271. The support wall 3272 may protrude radially inward from the outer circumferential wall 3271. The substrate 325 may be seated on the support wall 3272. The substrate 325 may be disposed to enable heat exchange with the support wall 3272. The support wall 3272 may include a first support portion 3272a. The first support portion 3272a may have a ring shape. The support wall 3272 may include a second support portion 3272b. The second support portion 3272b may have a ring shape. The first support portion 3272a and the second support portion 3272b may be spaced apart from each other in the radial direction of the heat dissipation member 327. The support wall 3272 may include a fence 3272c. The fence 3272c may be disposed between the first support portion 3272a and the second support portion 3272b. The fence 3272c may protrude from the first support portion 3272a or the second support portion 3272b.

According to an embodiment, the heat dissipation member 327 may include a heat dissipation fin 3273. The heat dissipation fin 3273 may protrude from the outer circumferential wall 3271. The heat dissipation fin 3273 may protrude radially outward from the outer circumferential wall 3271. A plurality of heat dissipation fins 3273 may be disposed. The plurality of heat dissipation fins 3273 may be spaced apart from each other in the circumferential direction of the heat dissipation member 327. The heat dissipation fin 3273 may correspond to the first hole 3223. The heat dissipation fin 3273 may correspond to the second hole 3234.

According to an embodiment, the heat dissipation member 327 may include an opening portion 3274. The opening portion 3274 may be formed in the outer circumferential wall 3271. The second substrate portion 3252 of the substrate 325 may be disposed in the opening portion 3274. The heat dissipation member 327 may support the second substrate portion 3252 disposed in the opening portion 3274. Electric charge generated in the substrate 325 may be discharged at the opening portion 3274 through the second substrate portion 3252. The heat dissipation member 327 may ground the substrate 325.

According to an embodiment, the lamp 328 may be at least partially exposed to the outside of the lens assembly 320. Electric charge outside the lens assembly 320 may move toward the lamp 328 and cause static electricity in an area near the lamp 328. The lens assembly 320 according to an embodiment of the disclosure may provide a wide discharge area to the lens assembly 320 by the heat dissipation member 327 extending along the circumference of the lens assembly 320. For example, electric charges that move toward the lamp 328 and cause static electricity may be discharged to the outside of the lens assembly 320 through the heat dissipation member 327. The heat dissipation member 327 may provide grounding to the lens assembly 320 and may include a metal material or a graphite material.

According to an embodiment, the heat dissipation member 327 may include a heat dissipation hole 3275. The heat dissipation hole 3275 may be formed in the outer circumferential wall 3271. A plurality of heat dissipation holes 3275 may be formed spaced apart in the circumferential direction of the heat dissipation member 327.

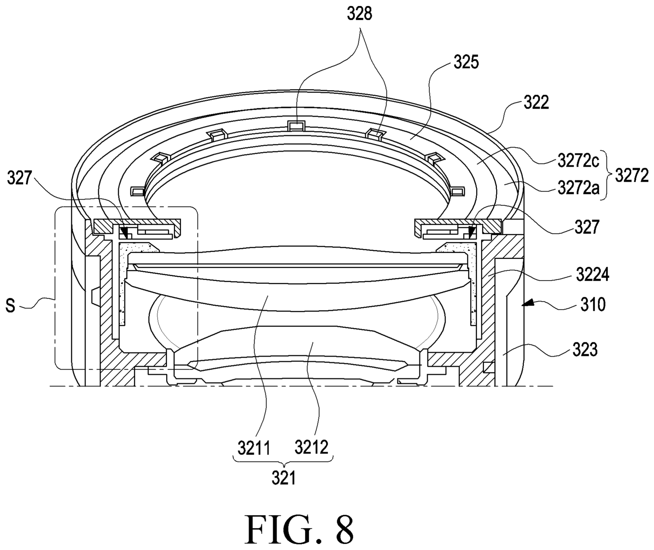

FIG. 7A is a view illustrating the lens assembly 320 viewed from one side so that one surface of the window 324 is visible according to an embodiment of the disclosure. FIG. 7B illustrates a state in which the window (e.g., the window 324 of FIG. 6) and the substrate cover (e.g., the substrate cover 326 of FIG. 6) are removed from the structure of FIG. 7A. FIG. 7A is a top view illustrating a portion of the wearable electronic device 300 according to an embodiment of the disclosure. FIG. 7B illustrates a state in which a portion of the structure of FIG. 7A is removed. The components described with reference to FIGS. 7A and 7B may be identical in whole or part to the components described with reference to FIGS. 1 to 6. The components described with reference to FIGS. 7A and 7B may be identical in whole or part to the components described with reference to FIGS. 8 to 13.

According to an embodiment, the second lens barrel 323 may form an outer circumferential surface of the lens assembly 320. The window 324 may be positioned inside the lens assembly 320 rather than the outer circumferential surface of the second lens barrel 323. A portion of the first lens barrel 322 (e.g., the lens barrel protrusion 3222 of FIG. 6) may be positioned radially outward from the second lens barrel 323.

According to an embodiment, the substrate 325 may be seated on the support wall 3272 of the heat dissipation member 327. The first substrate portion 3251 may be positioned radially inside the fence 3272c. The first substrate portion 3251 may be seated on the second support portion (e.g., the second support portion 3272b of FIG. 6). The first substrate portion 3251 may be supported by the second support portion (e.g., the second support portion 3272b of FIG. 6) and the fence 3272c. The second substrate portion 3252 may be disposed inside the opening portion 3274. A portion of the fence 3272c may be cut, and the second substrate portion 3252 may be disposed in the cut portion of the fence 3272c.

According to an embodiment, the lamp 328 may be disposed on the first substrate portion 3251. The plurality of lamps 328 may be spaced apart from each other along the circumferential direction of the lens assembly 320.

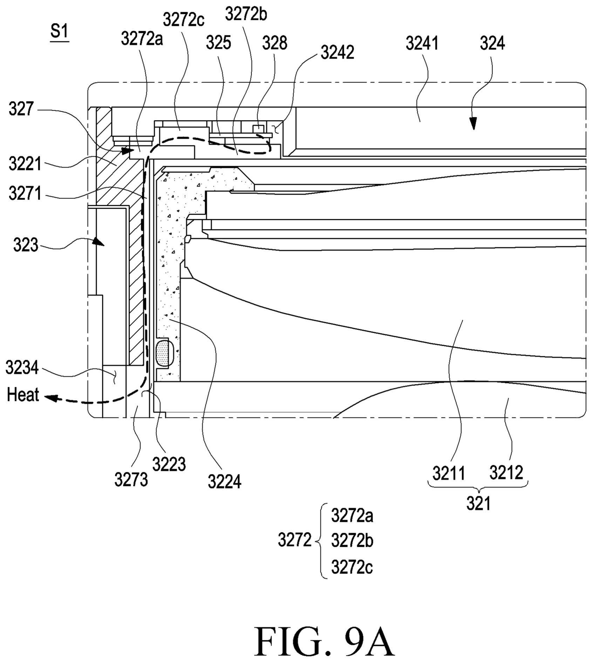

FIG. 8 illustrates the structure of FIG. 7B cut along line A-A'. For example, the lens assembly 320 is cut along line A-A' illustrated in FIG. 7B. The components described with reference to FIG. 8 may be identical in whole or part to the components described with reference to FIGS. 1 to 7B. The components described with reference to FIG. 8 may be identical in whole or part to the components described with reference to FIGS. 9A to 13.

According to an embodiment, a plurality of lenses 321 may be disposed. The lens 321 may include a first lens 3211. The lens 321 may include a second lens 3212. The first lens 3211 and the second lens 3212 may be spaced apart from each other. However, the number of lenses 321 is not limited thereto. For example, three or more lenses 321 may be disposed. The spacing between the plurality of lenses 321 may be adjusted according to rotation of the lens barrels 322, 323. For example, the spacing between the first lens 3211 and the second lens 3212 may be adjusted by rotating the lens barrels 322, 323.

According to an embodiment, the lens barrels 322, 323 may be coupled to the housing 301. The lens 321 may be disposed inside the lens barrels 322, 323. The lens assembly 320 may include a lens support portion 3224. The lens support portion 3224 may be a portion of the first lens barrel 322. The lens support portion 3224 may protrude radially inward from the first lens barrel 322. The lens support portion 3224 may be coupled to the lens 321. The lens support portion 3224 according to an embodiment of the disclosure may be detachably coupled to the lens barrels 322, 323 together with the lens 321. The lens support portion 3224 and the lens 321 may be attached to and detached from the first lens barrel 322. The lens support portion 3224 and the lens 321 may be configured as a module and coupled to the first lens barrel 322.

According to an embodiment, the substrate 325 may be supported by the support wall 3272. The substrate 325 may be spaced apart from the lens 321. The lamp 328 may be spaced apart from the lens 321.

According to an embodiment, the heat dissipation member 327 may be disposed to enable heat exchange with the substrate 325. The heat dissipation member 327 may transfer heat generated from the lamp 328 and the substrate 325 in a direction away from the user's eye. The heat dissipation member 327 may extend along a direction in which the substrate 325 extends. The lens support portion 3224 may be disposed between the lens 321 and the heat dissipation member 327. The lens support portion 3224 may include a material having lower thermal conductivity than the heat dissipation member 327. The lens support portion 3224 may include a plastic material.

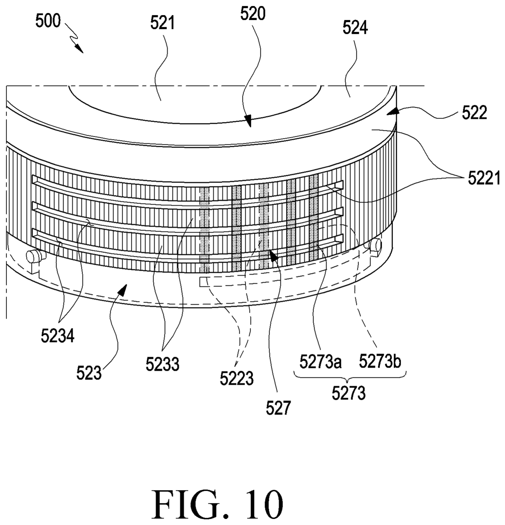

FIG. 9A is an enlarged view illustrating area S illustrated in FIG. 8 according to an embodiment (S1) of the disclosure. The components described with reference to FIG. 9A may be identical in whole or part to the components described with reference to FIGS. 1 to 8. The components described with reference to FIG. 9A may be identical in whole or part to the components described with reference to FIGS. 10 to 13.

According to an embodiment, the window 324 may include a window body 3241. The window body 3241 may have a ring shape. The window body 3241 may extend to correspond to the shape of the substrate 325.

According to an embodiment, the lens assembly 320 may include a heat dissipation space 3242. The window body 3241 may form a space inside its circumferential wall, and the heat dissipation space 3242 may be formed by the window body 3241. The heat dissipation space 3242 may be surrounded by the circumferential wall of the window body 3241. The heat dissipation space 3242 may be formed between the window body 3241 and the heat dissipation member 327. The substrate 325 and the lamp 328 may be disposed inside the heat dissipation space 3242. The substrate 325 and the lamp 328 may emit heat to the inside of the heat dissipation space 3242.

According to an embodiment, the substrate 325 may be disposed between the window body 3241 and the second support portion 3272b. The lamp 328 may be disposed between the substrate 325 and the window body 3241. The lamp 328 may emit infrared light toward the window body 3241. The second support portion 3272b and the fence 3272c may support the substrate 325.

According to an embodiment, the heat dissipation member 327 may be disposed to enable heat exchange with the substrate 325 and the lamp 328. The heat dissipation member 327 may face the heat dissipation space 3242. The support wall 3272 may extend in a direction in which the substrate 325 extends and in a direction in which the plurality of lamps 328 are spaced apart from each other. The support wall 3272 may absorb heat generated from the lamp 328.

According to an embodiment, the outer circumferential wall 3271 may extend in the circumferential direction of the lens 321. The outer circumferential wall 3271 may be disposed between the first circumferential wall 3221 and the lens support portion 3224. The outer circumferential wall 3271 may extend in a direction in which the support wall 3272 extends. Heat absorbed by the support wall 3272 may be diffused to the outer circumferential wall 3271. The outer circumferential wall 3271 may be positioned radially outward from the lamp 328 in the lens assembly 320.

According to an embodiment, the heat dissipation fin 3273 may be inserted into the first hole 3223. The heat dissipation fin 3273 may face the second hole 3234.

According to an embodiment, heat generated from the lamp 328 may be transferred to the substrate 325. Heat transferred to the substrate 325 may be diffused in the extending direction of the substrate 325. Heat diffused in the extending direction of the substrate 325 may be transferred to the support wall 3272. Heat transferred to the support wall 3272 may be transferred to the outer circumferential wall 3271. Heat transferred to the outer circumferential wall 3271 may escape to the outside of the lens assembly 320 through the first hole 3223 and the second hole 3234. A portion of heat transferred to the outer circumferential wall 3271 may escape to the outside of the lens assembly 320 through the heat dissipation fin 3273.

According to an embodiment, at least a portion of the heat dissipation member 327 may include a metal material. For example, in the cylindrical heat dissipation member 327, an area corresponding to a portion of an arc may include a metal material, and an area corresponding to the remaining arc may include a non-metal material. However, the entire cylindrical heat dissipation member 327 may include a metal material. The lens barrels 322, 323 may include a non-metal material. For example, in the cylindrical lens barrels 322, 323, an area corresponding to a portion of an arc may include a non-metal material, and an area corresponding to the remaining arc may include a metal material. However, the entire cylindrical lens barrels 322, 323 may include a non-metal material. The heat dissipation member 327 may include a material having higher thermal conductivity than the lens barrels 322, 323. For example, the heat dissipation member 327 may include a metal material, and the lens barrels 322, 323 may include a plastic material. The lens support portion 3224 may include a non-metal material. The lens support portion 3224 may include a material having lower thermal conductivity than the heat dissipation member 327. The lens support portion 3224 may block heat transferred to the heat dissipation member 327 from being transferred to the lens 321.

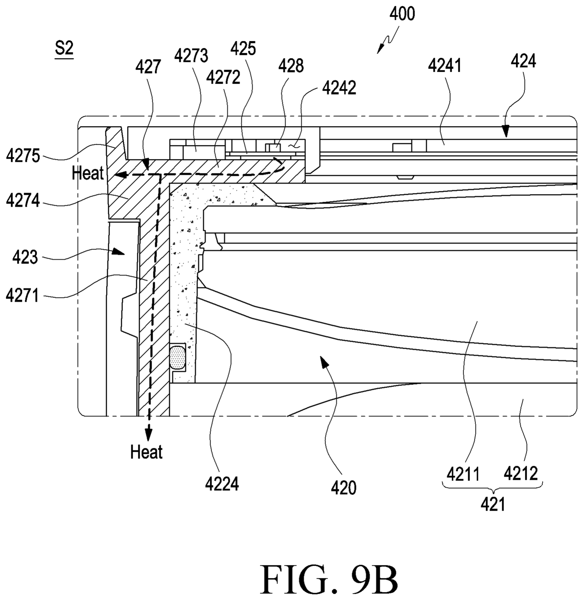

FIG. 9B is an enlarged view illustrating area S illustrated in FIG. 8 according to an embodiment (S2) of the disclosure. The components described with reference to FIG. 9B may be identical in whole or part to the components described with reference to FIGS. 1 to 9A. The components described with reference to FIG. 9B may be identical in whole or part to the components described with reference to FIGS. 10 to 13.

According to an embodiment, the electronic device 400 may include a lens assembly 420. The description of the electronic device 400 and components of the electronic device 400 may be the same as the description of the electronic device 300 and components of the electronic device 300 described with reference to FIGS. 1 to 9A. The description of the lens assembly 420 and components of the lens assembly 420 may be the same as the description of the lens assembly 320 and components of the lens assembly 320 described with reference to FIGS. 1 to 9A. For example, the lens assembly 420 may include a lens 421, a window 424 including a window body 4241, a heat dissipation space 4242, a substrate 425, a lamp 428, a lens barrel 423, and a lens support portion 4224. The description of the components (e.g., the lens 421, the window body 4241, the window 424, the heat dissipation space 4242, the substrate 425, the lamp 428, the lens barrel 423, the lens support portion 4224) may be the same as the description of the components (e.g., the lens 321, the window body 3241, the window 324, the heat dissipation space 3242, the substrate 325, the lamp 328, the lens barrel 323, the lens support portion 3224) described with reference to FIGS. 1 to 9A.

According to an embodiment, the lens assembly 420 may include a heat dissipation member 427. The heat dissipation member 427 may face the heat dissipation space 4242. The heat dissipation member 427 may support the substrate 425. The substrate 425 may be disposed between the window 424 and the heat dissipation member 427. The heat dissipation space 4242 may be formed between the window 424 and the heat dissipation member 427. The heat dissipation member 427 may be disposed to enable heat exchange with the substrate 425 and the lamp 428. Heat generated from the lamp 428 may be transferred to the heat dissipation member 427. Heat transferred to the heat dissipation member 427 may be discharged to the outside of the lens assembly 420. The heat dissipation member 427 may be disposed between the lens support portion 4224 and the lens barrel 423.

According to an embodiment, at least a portion of the heat dissipation member 427 may be exposed to the outside of the lens assembly 420. At least a portion of the lens barrel (e.g., the lens barrels 322, 323 of FIG. 9A) may be integral with the heat dissipation member 427. For example, the first lens barrel (e.g., the first lens barrel 322 of FIG. 6) may be formed integrally with the heat dissipation member (e.g., the heat dissipation member 327 of FIG. 6) to configure the heat dissipation member 427 of FIG. 9B. At least a portion of the heat dissipation member 427 may include a metal material. The heat dissipation member 427 may include a heat dissipation hole (e.g., the first hole 3223 of FIG. 6). The heat dissipation hole of the heat dissipation member 427 may communicate with the outside of the lens assembly 420.

According to an embodiment, the heat dissipation member 427 may include an outer circumferential wall 4271. The outer circumferential wall 4271 may extend in a direction in which the substrate 425 extends. The outer circumferential wall 4271 may extend along the circumferential direction of the lens 421. The outer circumferential wall 4271 may have a cylindrical shape. The outer circumferential wall 4271 may be disposed between the lens barrel 423 and the lens support portion 4224.

According to an embodiment, the heat dissipation member 427 may include a support wall 4272. The support wall 4272 may extend in a direction in which the substrate 425 extends. The support wall 4272 may have a ring shape. The support wall 4272 may protrude radially inward from the outer circumferential wall 4271 in the lens assembly 420. The substrate 425 may be disposed between the window body 4241 and the support wall 4272.

According to an embodiment, the heat dissipation member 427 may include a fence 4273. The fence 4273 may protrude from the support wall 4272 toward the window 424. The substrate 425 may be positioned in a first direction (e.g., +Y-axis direction of FIG. 2) with respect to the support wall 4272, and the fence 4273 may protrude from the support wall 4272 in the first direction. The fence 4273 may face the substrate 425 and the lamp 428. The fence 4273 may be disposed inside the heat dissipation space 4242. The fence 4273 may support the substrate 425. The substrate 425 may be disposed between the fence 4273 and the window body 4241.

According to an embodiment, the heat dissipation member 427 may include an outer wall protrusion 4274. The outer wall protrusion 4274 may protrude radially outward from the outer circumferential wall 4271 of the heat dissipation member 427. The outer wall protrusion 4274 may extend in a direction in which the outer circumferential wall 4271 extends. The outer wall protrusion 4274 may be exposed to the outside of the lens assembly 420. The outer wall protrusion 4274 may support the lens barrel 423.

According to an embodiment, the heat dissipation member 427 may include an edge 4275. The edge 4275 may protrude from the outer wall protrusion 4274. The edge 4275 may protrude from the support wall 4272. The edge 4275 may extend in a direction in which the window 424 extends. The edge 4275 may have a rim shape. The edge 4275 may support the window 424. The window 424 may be disposed radially inside the edge 4275.

According to an embodiment, heat generated from the lamp 428 may be transferred to the substrate 425. Heat transferred to the substrate 425 may be diffused in the extending direction of the substrate 425. Heat diffused in the extending direction of the substrate 425 may be transferred to the support wall 4272. Heat transferred to the support wall 4272 may be transferred to the outer circumferential wall 4271 and the outer wall protrusion 4274. The lens assembly 420 may include a first hole (e.g., the first hole 3223 of FIG. 9A), a second hole (e.g., the second hole 3234 of FIG. 9A), and a heat dissipation fin (e.g., the heat dissipation fin 3273 of FIG. 9A) as illustrated in FIG. 9A. Heat transferred to the outer circumferential wall 4271 may escape to the outside of the lens assembly 420 through the first hole (e.g., the first hole 3223 of FIG. 9A) and the second hole (e.g., the second hole 3234 of FIG. 9A). A portion of heat transferred to the outer circumferential wall 4271 may escape to the outside of the lens assembly 420 through the heat dissipation fin (e.g., the heat dissipation fin 3273 of FIG. 9A). The outer wall protrusion 4274 may be exposed to the outside of the lens assembly 420, and heat transferred to the outer wall protrusion 4274 may be discharged to the outside of the lens assembly 420.

According to an embodiment, at least a portion of the heat dissipation member 427 may include a metal material. For example, in the cylindrical heat dissipation member 427, an area corresponding to a portion of an arc may include a metal material, and an area corresponding to the remaining arc may include a non-metal material. However, the entire cylindrical heat dissipation member 427 may include a metal material. The lens barrel 423 may include a non-metal material. For example, in the cylindrical lens barrel 423, an area corresponding to a portion of an arc may include a non-metal material, and an area corresponding to the remaining arc may include a metal material. However, the entire cylindrical lens barrel 423 may include a non-metal material. The heat dissipation member 427 may include a material having higher thermal conductivity than the lens barrel 423. For example, the heat dissipation member 427 may include a metal material, and the lens barrel 423 may include a plastic material. The lens support portion 4224 may include a non-metal material. The lens support portion 4224 may include a material having lower thermal conductivity than the heat dissipation member 427. The lens support portion 4224 may block heat transferred to the heat dissipation member 427 from being transferred to the lens 421.

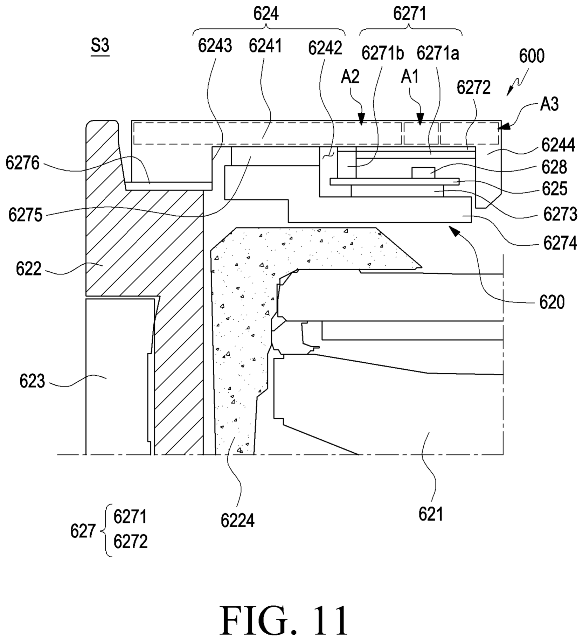

FIG. 10 illustrates a portion of the lens assembly 520 of a wearable electronic device 500 according to an embodiment of the disclosure. FIG. 10 illustrates a portion of a wearable electronic device 500 according to an embodiment of the disclosure. The components described with reference to FIG. 10 may be identical in whole or part to the components described with reference to FIGS. 1 to 9B. Some or all of the components described with reference to FIG. 10 may be the same as those described with reference to FIGS. 11 to 13.

According to an embodiment, the electronic device 500 may include a lens assembly 520. The lens assembly 520 may have a cylindrical shape. The description of the lens assembly 520 of FIG. 10 and components of the lens assembly 520 may be the same as the description of the lens assembly 320 and components of the lens assembly 320 described with reference to FIGS. 1 to 9A. For example, the lens assembly 520 may include a lens 521, a first lens barrel 522, a window 524, and a heat dissipation member 527, and the description of the components (e.g., the lens 521, the first lens barrel 522, the window 524, the heat dissipation member 527) may be the same as the description of the components (e.g., the lens 321, the first lens barrel 322, the window 324, the heat dissipation member 327) illustrated in FIGS. 1 to 9A.

According to an embodiment, the lens assembly 520 may include a second lens barrel 523. The second lens barrel 523 may be coupled to the first circumferential wall 5221 of the first lens barrel 522. The second lens barrel 523 may surround at least a portion of the first circumferential wall 5221.

According to an embodiment, the second lens barrel 523 may include a plurality of boundary walls 5233. The plurality of boundary walls 5233 may surround at least a portion of the first circumferential wall 5221. The plurality of boundary walls 5233 may be spaced apart from each other in a direction crossing (e.g., perpendicular to) a direction in which the first lens barrel 522 extends. The plurality of boundary walls 5233 may be a portion of the second lens barrel 523.

According to an embodiment, the second lens barrel 523 may include a second hole 5234. The second hole 5234 may be formed between the plurality of boundary walls 5233. A plurality of second holes 5234 may be formed. The plurality of second holes 5234 may be spaced apart from each other in a direction crossing (e.g., perpendicular to) a direction in which the first lens barrel 522 extends. The second hole 5234 may extend along the extending direction of the first lens barrel 522. The second hole 5234 may extend along the circumferential direction of the lens 521.

According to an embodiment, the first lens barrel 522 may include a first hole 5223. The heat dissipation member 527 may include a heat dissipation fin 5273. The description of the first hole 5223 may be the same as the description of the first hole 3223 illustrated in FIG. 6. The description of the heat dissipation fin 5273 may be the same as the description of the heat dissipation fin 3273 illustrated in FIG. 6. The heat dissipation fin 5273 may be inserted into the first hole 5223. The first hole 5223 and the heat dissipation fin 5273 may extend in a direction crossing (e.g., perpendicular to) the second hole 5234. The boundary wall 5233 may cover at least a portion of the first hole 5223 and the heat dissipation fin 5273. The heat dissipation fin 5273 may include a first fin portion 5273a exposed to the outside through the second hole 5234. The heat dissipation fin 5273 may include a second fin portion 5273b covered by the boundary wall 5233.

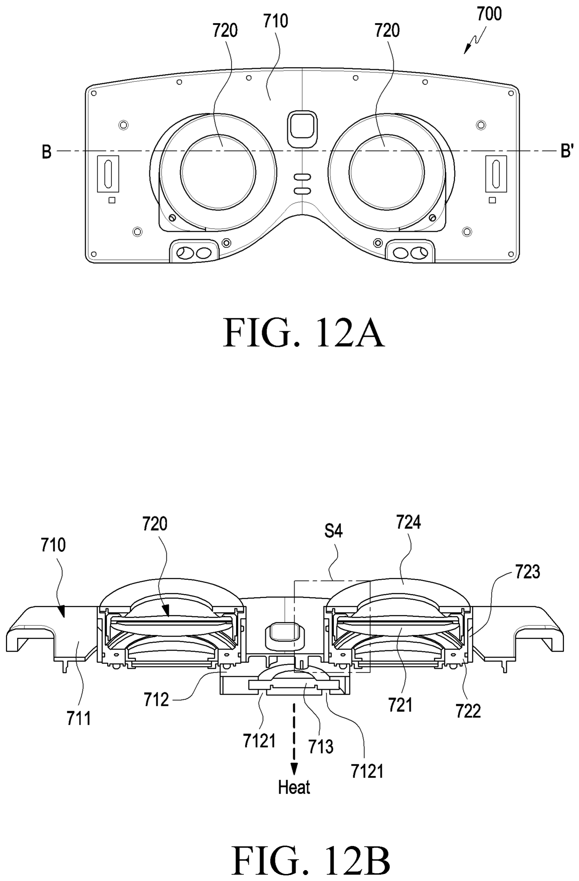

FIG. 11 is a cross-sectional view illustrating a portion of a wearable electronic device according to an embodiment of the disclosure. For example, this is an enlarged view illustrating area S illustrated in FIG. 8 according to an embodiment (S3) of the disclosure. An electronic device 600 according to an embodiment (S3) of the disclosure includes a lens assembly 620. The components described with reference to FIG. 11 may be identical in whole or part to the components described with reference to FIGS. 1 to 9B. The components described with reference to FIG. 11 may be identical in whole or part to the components described with reference to FIGS. 12A to 13.

According to an embodiment, the lens assembly 620 may include a lens 621, a first lens barrel 622, a second lens barrel 623, a window 624, a substrate 625, and a lamp 628. The description of the components of the lens assembly 620 (e.g., the lens 621, the first lens barrel 622, the second lens barrel 623, the window 624, the substrate 625, the lamp 628) may be the same as the description of the components of the lens assembly 320 (e.g., the lens 321, the first lens barrel 322, the second lens barrel 323, the window 324, the substrate 325, the lamp 328) described with reference to FIGS. 1 to 9A.

According to an embodiment, the lens assembly 620 may not include a heat dissipation member (e.g., the heat dissipation member 327 of FIG. 9A or the heat dissipation member 427 of FIG. 9B), unlike the embodiments of FIGS. 1 to 9B. The lens assembly 620 may include a thermal insulation member 627. The thermal insulation member 627 may be coupled to the window 624. The thermal insulation member 627 may face the lamp 628. The thermal insulation member 627 may block heat generated from the lamp 628 from being discharged to the outside of the lens assembly 620.

According to an embodiment, the window 624 may be divided into a plurality of areas A1, A2, A3. The window 624 may include a first area A1 facing the lamp 628. The window 624 may include a second area A2 and a third area A3 not facing the lamp 628. The first area A1 may be positioned between the second area A2 and the third area A3. The first area A1 of the window 624 facing the lamp 628 may include a transparent material or a material that transmits infrared (IR) light. The thermal insulation member 627 may be disposed between the first area A1 of the window 624 and the lamp 628 and may include a transparent material or a material that transmits infrared (IR) light. According to an embodiment of the disclosure, thermal insulation member 627 may be disposed in the second area A2 or the third area A3 of the window 624 and may include an opaque material. According to an embodiment of the disclosure, thermal insulation member 627 may be disposed in the second area A2 or the third area A3 of the window 624 and may include a transparent material or a material that transmits infrared (IR) light.

According to an embodiment, the lens assembly 620 may include a lens 621 and lens barrels 622, 623. The lens 621 may be disposed inside the lens barrels 622, 623. The lens barrels 622, 623 may surround the lens 621. The lens barrels 622, 623 may include a first lens barrel 622 and a second lens barrel 623. The lens assembly 620 may include a lens support portion 6224. The lens support portion 6224 may be disposed inside the lens barrels 622, 623. The lens support portion 6224 may surround the lens 621.

According to an embodiment, the lens assembly 620 may include a window 624. The window 624 may extend along a direction in which the substrate 625 extends. The window 624 may have a ring shape. The window 624 may include a window body 6241 and a heat dissipation space 6242. The description of the window body 6241 and the heat dissipation space 6242 may be the same as the description of the components (e.g., the window body 3241, the heat dissipation space 3242) described with reference to FIG. 9A. The window 624 may include a window edge 6243. The window edge 6243 may be coupled to the first lens barrel 622. The window edge 6243 may be positioned radially outward from the lamp 628 in the lens assembly 620. The window 624 may include a window inner wall 6244. The window inner wall 6244 may have a ring shape. The heat dissipation space 6242 may be formed between the window edge 6243 and the window inner wall 6244.

According to an embodiment, the lens assembly 620 may include a thermal insulation member 627. The thermal insulation member 627 may be disposed between the window 624 and the lamp 628. The thermal insulation member 627 may be coupled to the window body 6241. The thermal insulation member 627 may be disposed inside the heat dissipation space 6242. The thermal insulation member 627 may extend in a direction in which the substrate 625 extends. The thermal insulation member 627 may have a ring shape.

According to an embodiment, thermal insulation member 627 may include a thermal insulator 6271. The thermal insulator 6271 may be disposed between the window 624 and the lamp 628. The thermal insulator 6271 may be coupled to the substrate 625. The thermal insulator 6271 may include a first thermal insulator 6271a. The first thermal insulator 6271a may be spaced apart from the substrate 625 and the lamp 628. The first thermal insulator 6271a may extend in a direction in which the substrate 625 extends. The thermal insulator 6271 may include a second thermal insulator 6271b. The second thermal insulator 6271b may be coupled to the substrate 625. The second thermal insulator 6271b may protrude from the first thermal insulator 6271a toward the substrate 625. The second thermal insulator 6271b may extend in a direction in which the substrate 625 extends. The lamp 628 may be positioned between the second thermal insulator 6271b and the window inner wall 6244.

According to an embodiment, thermal insulation member 627 may include an adhesive member 6272. The adhesive member 6272 may be disposed between the window 624 and thermal insulator 6271. The adhesive member 6272 may couple the window 624 and thermal insulator 6271.

According to an embodiment, the adhesive member 6272 may be disposed between the first area A1 of the window 624 and the lamp 628 and may include a transparent material or a material that transmits infrared (IR) light. According to an embodiment of the disclosure, the adhesive member 6272 may be disposed in the second area A2 or the third area A3 of the window 624 and may include an opaque material. According to an embodiment of the disclosure, the adhesive member 6272 may be disposed in the second area A2 or the third area A3 of the window 624 and may include a transparent material or a material that transmits infrared (IR) light.

According to an embodiment, the lens assembly 620 may include a substrate adhesive member 6273. The lens assembly 620 may include a support block 6274. The lens assembly 620 may include a block adhesive member 6275. The lens assembly 620 may include a window adhesive member 6276. The substrate adhesive member 6273 may be disposed between the substrate 625 and the support block 6274 and may couple the substrate 625 and the support block 6274. The thermal conductivity of the substrate adhesive member 6273 may be greater than thermal conductivity of thermal insulation member 627. The support block 6274 may support the substrate 625. The support block 6274 may be spaced apart from the window 624, and the block adhesive member 6275 may couple the support block 6274 and the window 624. The thermal conductivity of the support block 6274 may be greater than thermal conductivity of thermal insulation member 627. The window adhesive member 6276 may couple the window edge 6243 and the first lens barrel 622.

According to an embodiment, heat generated from the lamp 628 may be transferred to the substrate 625. Heat traveling from the lamp 628 toward the window 624 may be blocked by thermal insulation member 627. Heat generated from the lamp 628 may be discharged to the outside of the lens assembly 620 through the substrate 625 and the support block 6274.

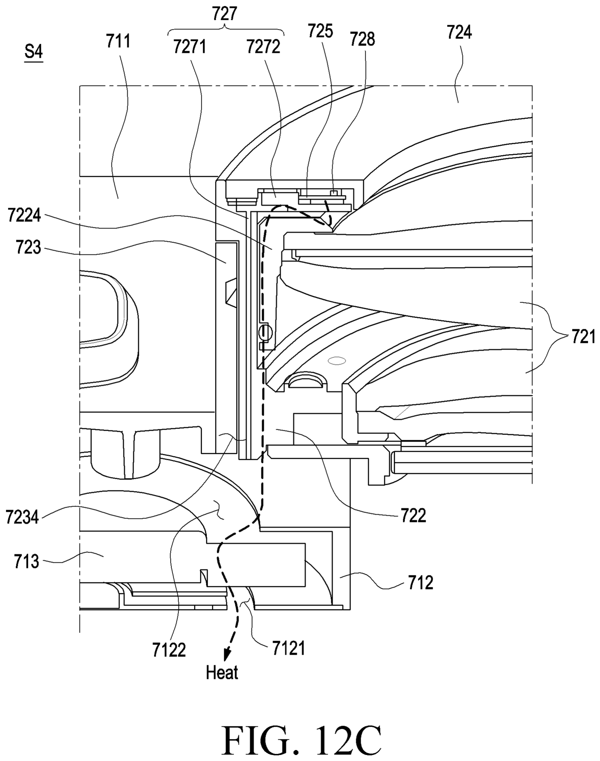

FIG. 12A is a side view illustrating a wearable electronic device 700 according to an embodiment of the disclosure. FIG. 12B is a view illustrating the wearable electronic device 700 cut along line B-B' illustrated in FIG. 12A. FIG. 12C is an enlarged view illustrating area S4 illustrated in FIG. 12B. The components described with reference to FIGS. 12A to 12C may be identical in whole or part to the components described with reference to FIGS. 1 to 11.

According to an embodiment, the wearable electronic device 700 may include a housing 710. The wearable electronic device 700 may include a lens assembly 720. The plurality of lens assemblies 720 may be disposed. The lens assembly 720 may be coupled to the housing 710. The description of the housing 710 and the lens assembly 720 may be the same as the description of the housing 301 and the lens assembly 320 described with reference to FIGS. 1 to 9A.

According to an embodiment, the lens assembly 720 may include a lens 721, a first lens barrel 722, a second lens barrel 723, a window 724, and a heat dissipation member 727. The description of the components of the lens assembly 720 (e.g., the lens 721, the first lens barrel 722, the second lens barrel 723, the window 724, the heat dissipation member 727) may be the same as the description of the components (e.g., the lens 321, the first lens barrel 322, the second lens barrel 323, the window 324, the heat dissipation member 327 of FIG. 9A) described with reference to FIGS. 1 to 9A.

According to an embodiment, the housing 710 may include a plate 711. The plate 711 may be coupled to the lens assembly 720. The housing 710 may include a fan housing 712. The fan housing 712 may be coupled to the plate 711. The inner space of the fan housing 712 may communicate with the inner space of the lens assembly 720. When the user wears the wearable electronic device 700, the lens assembly 720 may protrude from the plate 711 toward the user's eye, and the fan housing 712 may protrude from the plate 711 in a direction opposite to the direction in which the lens assembly 720 protrudes. The wearable electronic device 700 may include a fan 713. The fan 713 may be disposed inside the fan housing 712. The fan 713 may blow air in the inner space of the lens assembly 720. The fan housing 712 may include an air outlet 7121. The fan 713 may blow air through the air outlet 7121.

According to an embodiment, the lens assembly 720 may include a lens support portion 7224, a substrate 725, a lamp 728, a first lens barrel 722, a second lens barrel 723, and a heat dissipation member 727 including an outer circumferential wall 7271 and a support wall 7272. The description of the above-mentioned components of the lens assembly 720 (e.g., the lens support portion 7224, the substrate 725, the lamp 728, the first lens barrel 722, the second lens barrel 723, the outer circumferential wall 7271, the support wall 7272) may be the same as the description of the components (e.g., the lens support portion 3224, the substrate 325, the lamp 328, the first lens barrel 322, the second lens barrel 323, the outer circumferential wall 3271, the support wall 3272) described with reference to FIG. 9A.

According to an embodiment, the lens assembly 720 may include a heat dissipation hole 7234. The heat dissipation hole 7234 may connect the inner space of the lens assembly 720 and the inner space of the fan housing 712. The heat dissipation hole 7234 may be formed between the second lens barrel 723 and the plate 711. The heat dissipation hole 7234 may be formed by opening a portion of the plate 711.

According to an embodiment, the heat dissipation member 727 may extend toward the fan 713. The heat dissipation member 727 may extend toward the fan 713 through the heat dissipation hole 7234. According to an embodiment of the disclosure, the heat dissipation member 727 may extend toward the fan 713 by penetrating the plate 711, and the heat dissipation hole 7234 may not be formed.

According to an embodiment, the fan housing 712 may include a fan housing inlet 7122. The fan housing inlet 7122 may face the heat dissipation hole 7234. Air that has passed through the heat dissipation hole 7234 may flow to the fan 713 through the fan housing inlet 7122, and the fan 713 may discharge air that has passed through the fan housing inlet 7122 to the air outlet 7121.

According to an embodiment, heat generated from the lamp 728 may be transferred to the substrate 725. Heat transferred to the substrate 725 may be transferred to the heat dissipation member 727. Heat transferred to the heat dissipation member 727 may be conducted throughout the heat dissipation member 727. When the fan 713 is operated, convection may occur between the fan 713 and the heat dissipation member 727. Heat conducted to the heat dissipation member 727 may be dissipated to the fan 713, and the fan 713 may discharge air including heat dissipated from the heat dissipation member 727 to the air outlet 7121.

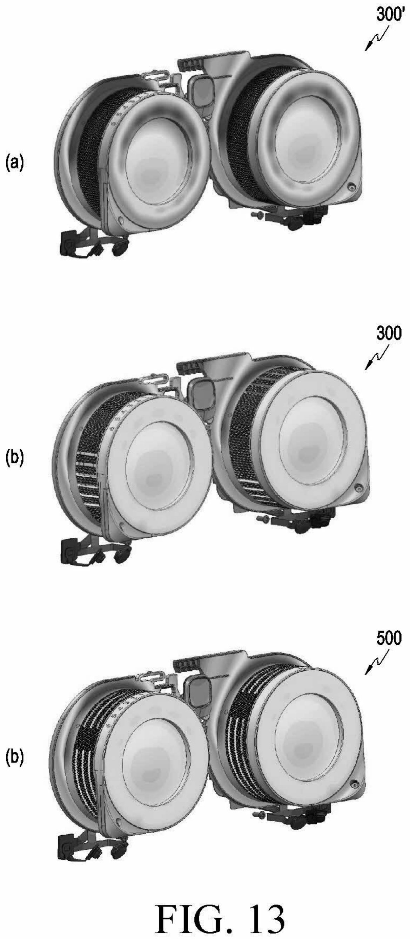

FIG. 13 is a contour comparing effects of wearable electronic devices 300, 500 according to various embodiments of the disclosure with a comparative embodiment. FIG. 13 is a contour describing effects of a wearable electronic device according to an embodiment of the disclosure. FIG. 13(a) is a contour illustrating the distribution of heat in a wearable electronic device 300' according to a comparative embodiment. FIG. 13(b) is a contour illustrating the distribution of heat in the wearable electronic device 300 according to the embodiments of FIGS. 1 to 9A. FIG. 13(c) is a contour illustrating the distribution of heat in the wearable electronic device 500 according to the embodiment of FIG. 10.

Referring to FIG. 13, it can be identified that the heat generation degree in the lens assembly is reduced compared to the comparative embodiment due to the arrangement of the heat dissipation member (e.g., the heat dissipation member 327 of FIG. 9A or the heat dissipation member 527 of FIG. 10) according to the embodiments of the disclosure.

A wearable electronic device may be worn on the user's face to provide the user with visual information related to virtual reality or augmented reality. The wearable electronic device may emit infrared light to the user's eye to obtain information related to the user's eye (e.g., the position of the iris or pupil). The wearable electronic device includes a lamp that generates heat and a camera that detects light emitted from the lamp and reflected for obtaining the above-mentioned information related to the user's eye. The wearable electronic device including the above-mentioned lamp and camera may cause danger as heat generated from the lamp is directed toward the user.

An object of the disclosure may be to reduce the above-mentioned danger. Objects of the disclosure are not limited to the above-mentioned problem and may be variously determined within the scope that does not deviate from the spirit and scope of the disclosure.

An electronic device according to various embodiments of the disclosure may reduce heat directed toward the user by discharging heat generated from the lamp to the outside of the lens assembly through the heat dissipation member.

An electronic device according to various embodiments of the disclosure may have heat directed toward the user blocked by thermal insulation member facing the lamp.

Effects obtainable from the disclosure are not limited to the above-mentioned effects, and other effects not mentioned may be apparent to one of ordinary skill in the art from the following description.

A wearable electronic device (e.g., 300; 400; 500; 700 of FIGS. 6 to 13) according to an embodiment of the disclosure may include a display (e.g., 211 of FIG. 2) generating visual information.

The wearable electronic device (e.g., 300; 400; 500; 700 of FIGS. 6 to 13) according to an embodiment of the disclosure may include a lens (e.g., 321; 421; 521; 721 of FIGS. 6 to 13) configured to allow the visual information displayed on the display (e.g., 211 of FIG. 2) to be transmitted through the lens.

The wearable electronic device (e.g., 300; 400; 500; 700 of FIGS. 6 to 13) according to an embodiment of the disclosure may include a plurality of lamps (e.g., 328; 428; 528; 728 of FIGS. 6 to 13) spaced apart from each other along a circumferential direction of the lens (e.g., 321; 421; 521; 721 of FIGS. 6 to 13).

The wearable electronic device (e.g., 300; 400; 500; 700 of FIGS. 6 to 13) according to an embodiment of the disclosure may include a substrate (e.g., 325; 425; 525; 725 of FIGS. 6 to 13) electrically connected to the plurality of lamps (e.g., 328; 428; 528; 728 of FIGS. 6 to 13) and extending along the circumferential direction of the lens (321; 421; 521; 721).

The wearable electronic device (e.g., 300; 400; 500; 700 of FIGS. 6 to 13) according to an embodiment of the disclosure may include a heat dissipation member (e.g., 327; 427; 527; 727 of FIGS. 6 to 13) having at least a portion extending in a direction in which the substrate (e.g., 325; 425; 525; 725 of FIGS. 6 to 13) extends so as to enable heat exchange with the substrate (e.g., 325; 425; 525; 725 of FIGS. 6 to 13).

The heat dissipation member (e.g., 327 of FIG. 6) according to an embodiment of the disclosure may include an outer circumferential wall (e.g., 3271 of FIG. 6) disposed to surround the lens (e.g., 321 of FIG. 6).

The heat dissipation member (e.g., 327 of FIG. 6) according to an embodiment of the disclosure may include a support wall (e.g., 3272 of FIG. 6) extending along a circumference of the outer circumferential wall (e.g., 3271 of FIG. 6) and the substrate (e.g., 325 of FIG. 6) is seated on the support wall.

The support wall (e.g., 3272 of FIG. 9A) according to an embodiment of the disclosure may include a fence (e.g., 3272c of FIG. 9A) disposed on a radially outer side of the substrate (e.g., 325 of FIG. 9A).

The wearable electronic device (e.g., 300 of FIG. 6) according to an embodiment of the disclosure may further include a window (e.g., 324 of FIG. 6) spaced apart from the support wall (e.g., 3272 of FIG. 6).

The plurality of lamps (e.g., 328 of FIG. 6) according to an embodiment of the disclosure may be disposed between the support wall (e.g., 3272 of FIG. 6) and the window (e.g., 324 of FIG. 6).

The wearable electronic device (e.g., 300 of FIG. 6) according to an embodiment of the disclosure may further include a window body (e.g., 3241 of FIG. 9A) spaced apart from the support wall (e.g., 3272 of FIG. 6), extending in a direction in which the substrate (e.g., 325 of FIG. 6) extends, and forming a heat dissipation space (e.g., 3242 of FIG. 9A) in which the substrate (e.g., 325 of FIG. 6) is disposed between the support wall (e.g., 3272 of FIG. 6) and the window body (e.g., 3241 of FIG. 9A).

The wearable electronic device (e.g., 300 of FIG. 6) according to an embodiment of the disclosure may further include a lens barrel (e.g., 322, 323 of FIG. 6) disposed to surround the heat dissipation member (e.g., 327 of FIG. 6).

The lens barrel (e.g., 322, 323 of FIG. 6) according to an embodiment of the disclosure may include a hole (e.g., 3223, 3234 of FIG. 6) opened toward an outside of the lens barrel (e.g., 322, 323 of FIG. 6) and facing the heat dissipation member (e.g., 327 of FIG. 6).

The heat dissipation member (e.g., 327 of FIG. 6) according to an embodiment of the disclosure may include a heat dissipation fin (e.g., 3273 of FIG. 6) protruding toward the hole (e.g., 3223, 3234 of FIG. 6) of the lens barrel (e.g., 322, 323 of FIG. 6).

The wearable electronic device (e.g., 300 of FIG. 6) according to an embodiment of the disclosure may include a first lens barrel (e.g., 322 of FIG. 6) surrounding the heat dissipation member (e.g., 327 of FIG. 6) and having a first hole (e.g., 3223 of FIG. 6) facing the heat dissipation member (e.g., 327 of FIG. 6).

The wearable electronic device (e.g., 300 of FIG. 6) according to an embodiment of the disclosure may include a second lens barrel (e.g., 323 of FIG. 6) coupled to the first lens barrel (e.g., 322 of FIG. 6) and having a second hole (e.g., 3234 of FIG. 6) at least partially facing the heat dissipation member (e.g., 327 of FIG. 6).

The first hole (e.g., 5223 of FIG. 10) and the second hole (e.g., 5234 of FIG. 10) according to an embodiment of the disclosure may extend in directions crossing each other.

The wearable electronic device (e.g., 300 of FIG. 6) according to an embodiment of the disclosure may include a lens support portion (e.g., 3224 of FIG. 9A) disposed to surround the lens (e.g., 321 of FIG. 6).

The wearable electronic device (e.g., 300 of FIG. 6) according to an embodiment of the disclosure may include a lens barrel (e.g., 322, 323 of FIG. 6) disposed to surround the heat dissipation member (e.g., 327 of FIG. 6).

The heat dissipation member (e.g., 327 of FIG. 6) according to an embodiment of the disclosure may be disposed between the lens support portion (e.g., 3224 of FIG. 9A) and the lens barrel (e.g., 322, 323 of FIG. 6).

The substrate (e.g., 325 of FIG. 6) according to an embodiment of the disclosure may include a first substrate portion (e.g., 3251 of FIG. 6) on which the plurality of lamps (e.g., 328 of FIG. 6) are disposed and extending in a direction in which the plurality of lamps (e.g., 328 of FIG. 6) are spaced apart from each other.

The substrate (e.g., 325 of FIG. 6) according to an embodiment of the disclosure may include a second substrate portion (e.g., 3252 of FIG. 6) extending in a direction crossing an extending direction of the first substrate portion (e.g., 3251 of FIG. 6).

The heat dissipation member (e.g., 327 of FIG. 6) according to an embodiment of the disclosure may include an opening portion (e.g., 3274 of FIG. 6) in which the second substrate portion (e.g., 3252 of FIG. 6) is disposed.

The thermal conductivity of the lens barrel (e.g., 322, 323 of FIG. 6) according to an embodiment of the disclosure may be smaller than thermal conductivity of the heat dissipation member (e.g., 327 of FIG. 6).

The wearable electronic device (e.g., 400 of FIG. 9B) according to an embodiment of the disclosure may include a lens assembly (e.g., 420 of FIG. 9B) including the lens (e.g., 421 of FIG. 9B), the plurality of lamps (e.g., 428 of FIG. 9B), the substrate (e.g., 425 of FIG. 9B), and the heat dissipation member (e.g., 427 of FIG. 9B).

The lens assembly (e.g., 420 of FIG. 9B) according to an embodiment of the disclosure may include a lens barrel (e.g., 423 of FIG. 9B) forming at least a portion of an outer circumferential surface of the lens assembly (e.g., 420 of FIG. 9B).

The heat dissipation member (e.g., 427 of FIG. 9B) according to an embodiment of the disclosure may surround at least a portion of the lens barrel (e.g., 423 of FIG. 9B) and may be exposed to an outside of the lens assembly (e.g., 420 of FIG. 9B).

The wearable electronic device (e.g., 700 of FIG. 12A) according to an embodiment of the disclosure may include a lens assembly (e.g., 720 of FIG. 12C) including the lens (e.g., 721 of FIG. 12C), the plurality of lamps (e.g., 728 of FIG. 12C), the substrate (e.g., 725 of FIG. 12C), and the heat dissipation member (e.g., 727 of FIG. 12C).

The wearable electronic device (e.g., 700 of FIG. 12A) according to an embodiment of the disclosure may include a housing (e.g., 710 of FIG. 12C) coupled to the lens assembly (e.g., 720 of FIG. 12C) and accommodating the display (e.g., 240 of FIG. 5).

The wearable electronic device (e.g., 700 of FIG. 12A) according to an embodiment of the disclosure may further include a fan (e.g., 713 of FIG. 12C) forming air flow inside the lens assembly (e.g., 720 of FIG. 12C).

The housing (e.g., 710 of FIG. 12B) according to an embodiment of the disclosure may include a plate (e.g., 711 of FIG. 12C) coupled to the lens assembly (e.g., 720 of FIG. 12C).

The housing (e.g., 710 of FIG. 12B) according to an embodiment of the disclosure may include a fan housing (e.g., 712 of FIG. 12C) protruding from the plate (e.g., 711 of FIG. 12C) in a direction opposite to a direction in which the lens assembly (e.g., 720 of FIG. 12C) is disposed and receiving the fan (e.g., 713 of FIG. 12C).

The fan (e.g., 713 of FIG. 12C) according to an embodiment of the disclosure may be configured to discharge heat of the heat dissipation member (e.g., 727 of FIG. 12C) to an outside of the housing (e.g., 710 of FIG. 12C).

A wearable electronic device (e.g., 600 of FIG. 11) according to an embodiment of the disclosure may include a display (e.g., 211 of FIG. 2) generating visual information, a lens (e.g., 621 of FIG. 11) configured to allow the visual information displayed on the display (e.g., 211 of FIG. 2) to be transmitted through the lens, a plurality of lamps (e.g., 628 of FIG. 11) spaced apart from each other along a circumferential direction of the lens (e.g., 621 of FIG. 11), a window (e.g., 624 of FIG. 11) through which the visual information transmitted through the lens (e.g., 621 of FIG. 11) and light emitted from the plurality of lamps (e.g., 628 of FIG. 11) are transmitted, a substrate (e.g., 625 of FIG. 11) electrically connected to the plurality of lamps (e.g., 628 of FIG. 11) and extending in a direction in which the plurality of lamps (e.g., 628 of FIG. 11) are spaced apart, and a thermal insulation member (e.g., 627 of FIG. 11) disposed between the plurality of lamps (e.g., 628 of FIG. 11) and the window (e.g., 624 of FIG. 11).

The thermal insulation member (e.g., 627 of FIG. 11) according to an embodiment of the disclosure may include a first thermal insulator (e.g., 6271a of FIG. 11) disposed between the window (e.g., 624 of FIG. 11) and the plurality of lamps (e.g., 628 of FIG. 11) and spaced apart from the plurality of lamps (e.g., 628 of FIG. 11).

The thermal insulation member (e.g., 627 of FIG. 11) according to an embodiment of the disclosure may include a second thermal insulator (e.g., 6271b of FIG. 11) extending from the first thermal insulator (e.g., 6271a of FIG. 11) toward the substrate (e.g., 625 of FIG. 11) and coupled to the substrate (e.g., 625 of FIG. 11).

The thermal insulation member (e.g., 627 of FIG. 11) according to an embodiment of the disclosure may be coupled to one surface of the window (e.g., 624 of FIG. 11) facing the plurality of lamps (e.g., 628 of FIG. 11).

The thermal insulation member (e.g., 627 of FIG. 11) according to an embodiment of the disclosure may include a thermal insulator (e.g., 6271 of FIG. 11) facing the plurality of lamps (e.g., 628 of FIG. 11).

The thermal insulation member (e.g., 627 of FIG. 11) according to an embodiment of the disclosure may include an adhesive member (e.g., 6272 of FIG. 11) coupling thermal insulator (e.g., 6271 of FIG. 11) and the window (e.g., 624 of FIG. 11).

The wearable electronic device (e.g., 600 of FIG. 11) according to an embodiment of the disclosure may further include a support block (e.g., 6274 of FIG. 11) spaced apart from the window (e.g., 624 of FIG. 11), forming a heat dissipation space (e.g., 6242 of FIG. 11) in which the plurality of lamps (e.g., 628 of FIG. 11) are disposed between the window (e.g., 624 of FIG. 11) and the support block, and on which the substrate (e.g., 625 of FIG. 11) is seated.

While the disclosure has been shown and described with reference to exemplary embodiments thereof, it will be apparent to those of ordinary skill in the art that various changes in form and detail may be made thereto without departing from the spirit and scope of the disclosure as defined by the following claims.

## Claims

1. A wearable electronic device (300; 400; 500; 700), comprising:
a display (211) configured to generate visual information;
a lens (321; 421; 521; 721) configured to allow the visual information displayed on the display (211) to be transmitted through the lens;
a plurality of lamps (328; 428; 528; 728) spaced apart from each other along a circumferential direction of the lens (321; 421; 521; 721);
a substrate (325; 425; 525; 725) electrically connected to the plurality of lamps (328; 428; 528; 728) and extending along the circumferential direction of the lens (321; 421; 521; 721); and
a heat dissipation member (327; 427; 527; 727), at least a portion of the heat dissipation member in contact with the substrate (325; 425; 525; 725) and extending in a direction in which the substrate (325; 425; 525; 725) extends.

2. The wearable electronic device of claim 1, wherein the heat dissipation member (327) includes:
an outer circumferential wall (3271) disposed to surround the lens (321); and
a support wall (3272) extending along a circumference of the outer circumferential wall (3271), wherein the substrate (325) is seated on the support wall.

3. The wearable electronic device of claim 2, wherein the support wall (3272) includes a fence (3272c) disposed on a radially outer side of the substrate (325).

4. The wearable electronic device of claim 2 or 3, further comprising a window (324) spaced apart from the support wall (3272), wherein the plurality of lamps (328) are disposed between the support wall (3272) and the window (324).

5. The wearable electronic device of any one of claims 2 to 4, wherein a window body (3241) spaced apart from the support wall (3272), extending in a direction in which the substrate (325) extends, and forming a heat dissipation space (3242) in which the substrate (325) is disposed between the support wall (3272) and the window body (3241).

6. The wearable electronic device of any one of claims 1 to 5, further comprising a lens barrel (322, 323) disposed to surround the heat dissipation member (327), wherein the lens barrel (322, 323) includes a hole (3223, 3234) opened toward an outside of the lens barrel (322, 323) and facing the heat dissipation member (327).

7. The wearable electronic device of claim 6, wherein the heat dissipation member (327) includes a heat dissipation fin (3273) protruding toward the hole (3223, 3234) of the lens barrel (322, 323).

8. The wearable electronic device of any one of claims 1 to 7, further comprising a lens barrel (322, 323) surrounding the heat dissipation member (327), wherein the lens barrel (322, 323) includes:
a first lens barrel (322) surrounding the heat dissipation member (327) and having a first hole (3223) facing the heat dissipation member (327); and
a second lens barrel (323) coupled to the first lens barrel (322) and having a second hole (3234) at least partially facing the heat dissipation member (327), and wherein the first hole (3223) and the second hole (3234) extend in directions crossing each other.

9. The wearable electronic device of any one of claims 1 to 8, further comprising:
a lens support portion (3224) disposed to surround the lens (321); and
a lens barrel (322, 323) disposed to surround the heat dissipation member (327), wherein the heat dissipation member (327) is disposed between the lens support portion (3224) and the lens barrel (322, 323).

10. The wearable electronic device of any one of claims 1 to 9, wherein the substrate (325) includes:
a first substrate portion (3251) on which the plurality of lamps (328) are disposed and extending in a direction in which the plurality of lamps (328) are spaced apart from each other; and
a second substrate portion (3252) extending in a direction crossing an extending direction of the first substrate portion (3251), and wherein the heat dissipation member (327) includes an opening portion (3274) in which the second substrate portion (3252) is disposed.

11. The wearable electronic device of any one of claims 1 to 10, further comprising a lens barrel (322, 323) surrounding the heat dissipation member (327) and positioned farther from the plurality of lamps (328) than the heat dissipation member (327), wherein a thermal conductivity of the lens barrel (322, 323) is smaller than a thermal conductivity of the heat dissipation member (327).

12. The wearable electronic device of any one of claims 1 to 11, further comprising a lens assembly (420) including the lens (421), the plurality of lamps (428), the substrate (425), and the heat dissipation member (427), wherein the lens assembly (420) includes a lens barrel (423) forming at least a portion of an outer circumferential surface of the lens assembly (420), and wherein the heat dissipation member (427) surrounds at least a portion of the lens barrel (423) and is exposed to an outside of the lens assembly (420).

13. The wearable electronic device of any one of claims 1 to 12, further comprising:
a lens assembly (720) including the lens (721), the plurality of lamps (728), the substrate (725), and the heat dissipation member (727);
a housing (710) coupled to the lens assembly (720) and accommodating the display (240); and
a fan (713) forming air flow inside the lens assembly (720).

14. The wearable electronic device of claim 13, wherein the housing (710) includes:
a plate (711) coupled to the lens assembly (720); and
a fan housing (712) protruding from the plate (711) in a direction opposite to a direction in which the lens assembly (720) is disposed and receiving the fan (713).

15. The wearable electronic device of claim 13 or 14, wherein the fan (713) is configured to discharge heat of the heat dissipation member (727) to an outside of the housing (710).
